# EUROPÄISCHE PATENTSCHRIFT

(11) **EP 1 982 360 B1**
(45) Veröffentlichungstag und Bekanntmachung des Hinweises auf die Patenterteilung: **17.08.2016**
(21) Anmeldenummer: 07711158.1
(22) Anmeldetag: 24.01.2007
(51) Int. Cl.: H01L 33/58, F21S 8/10, H01L 33/50

(54) **LUMINESZENZDIODEN-BAUELEMENT MIT GEHÄUSE**
LIGHT-EMITTING DIODE COMPRISING A HOUSING
DIODE ÉLECTROLUMINESCENTE COMPRENANT UN BOÎTIER

(30) Priorität: 06.02.2006 DE 102006005299
(43) Veröffentlichungstag der Anmeldung: 22.10.2008
(73) Patentinhaber: OSRAM Opto Semiconductors GmbH, 93055 Regensburg (DE)
(72) Erfinder: ENGL, Moritz, 93055 Regensburg (DE); REILL, Joachim, 93197 Zeitlarn (DE); WÜLLER, Martin, 48231 Warendorf (DE); SCHWENKSCHUSTER, Lukas, 71576 Burgstetten (DE)
(74) Vertreter: Epping - Hermann - Fischer
(86) Internationale Anmeldenummer: PCT/DE2007/000129
(87) Internationale Veröffentlichungsnummer: WO 2007/090365

(56) Entgegenhaltungen:
- EP-A- 1 418 381
- EP-A- 1 526 580
- WO-A-03/071352
- WO-A-2006/012842
- JP-A- 56 112 771
- JP-A- 2003 031 011
- US-A1- 2004 032 728

## Beschreibung

Die vorliegende Erfindung betrifft ein Lumineszenzdioden-Bauelement gemäß dem Oberbegriff von Anspruch 1 mit einem Gehäuse. Sie betrifft insbesondere ein Gehäuse für ein Scheinwerfer-Bauelement, das weißes Licht emittiert.

Es sind Gehäuse für elektromagnetische Strahlung emittierende optoelektronische Bauelemente mit einem Grundkörper bekannt, der eine Gehäusekavität definiert. Der Boden dieser Gehäusekavität ist für eine Montage eines Lumineszenzdiodenchips vorgesehen. Innenwände, welche die Gehäusekavität seitlich begrenzen, können in der Art eines Reflektors geformt sein, sodass ein Teil einer von dem Lumineszenzdiodenchip emittierten elektromagnetischen Strahlung mittels der Innenwände in einen gewünschten Strahl-Raumwinkel umgelenkt werden kann. Ein Bauelement mit einem derartigen Gehäuse ist beispielsweise in der DE 297 24 543 U1 offenbart. Das in dieser Druckschrift beschriebene Licht abstrahlende Halbleiterbauelement weist ein Lumineszenzkonversionselement auf. Ein Lumineszenzdiodenchip des Bauelements emittiert eine elektromagnetische Strahlung eines ersten Wellenlängenbereichs, die durch das Lumineszenzkonversionselement teilweise in eine Strahlung eines zweiten Wellenlängenbereichs umgewandelt wird. Wenn der erste Wellenlängenbereich blaues Licht und der zweite Wellenlängenbereich gelbes Licht umfasst, kann so beispielsweise durch eine additive Farbmischung weißes Licht erzeugt werden.

Wenn die Weglängen der von dem Lumineszenzdiodenchip emittierten elektromagnetischen Strahlung durch das Lumineszenzkonversionselement in Abhängigkeit vom Emissionswinkel unterschiedlich lang sind, wird in Abhängigkeit von der Weglänge ein unterschiedlich großer Anteil des Lichtes konvertiert. Dies kann dazu führen, dass die Farbe eines von dem Bauelement emittierten Lichtkegels inhomogen ist. Beispielsweise können die Randbereiche eines Strahlenkegels bei der Verwendung eines gelben Leuchtstoffes einen wesentlich höheren Gelbanteil aufweisen als mittige Bereiche des Strahlenkegels.

In der DE 297 24 543 U1 sind Lumineszenzkonversionselemente in Form einer dünnen, gleichmäßig dicken Schicht angegeben. Diese Schicht kann unmittelbar auf den Lumineszenzdiodenchip oder in einer Entfernung zum Lumineszenzdiodenchip im Strahlengang des Bauelements angeordnet sein. Durch derartige als dünne Schicht ausgebildete Lumineszenzkonversionselemente können Farbinhomogenitäten signifikant verringert werden.

Lumineszenzdioden-Bauelemente finden immer häufiger in Scheinwerfer- oder Projektionsapplikationen Anwendung. Ein Beispiel für einen Scheinwerfer, in dem elektromagnetische Strahlung emittierende Lumineszenzdiodenchips verwendet werden, ist in der DE 103 151 31 A1 angegeben. Es handelt sich hierbei um einen Scheinwerfer für Fahrzeuge, bei dem eine Mehrzahl von Lumineszenzdiodenchips in einer gemeinsamen Ausnehmung angeordnet sind. Die Ausnehmung weist auf einer in Lichtabstrahlrichtung gewandten Seite eine Randkante auf, die derart in räumlicher Anordnung zu den Lumineszenzdiodenchips steht, dass im Bereich der Randkanten ein vorgegebener Leuchtdichtegradient für eine Lichtverteilung des Scheinwerfers ausgebildet wird. Der Strahlenkegel wird mittels Optiken wie Projektionslinsen auf eine gewünschte Ebene projiziert.

Die Druckschrift US 2004/032728 A1 (GALLI ROBERT [US]; 19. Februar 2004) beschreibt ein Lumineszenzdioden-Bauelement gemäß dem Oberbegriff des Anspruchs 1.

Die Druckschrift EP 1 526 580 A (STANLEY ELECTRIC CO LTD [JP]; 27. April 2005) beschreibt ein Lumineszenzdioden-Bauelement, bei dem eine Abschirmschicht für die von der Lumineszenzdiode emittierte Strahlung auf der der Lumineszenzdiode zugewandten Seite eines optischen Bauteils vorgesehen ist.

Insbesondere bei Scheinwerferapplikationen für Kraftfahrzeuge ist neben der Realisierung einer vorgegebenen Lichtdichteverteilung des Strahlenkegels auch eine möglichst gleichmäßige Farbwiedergabe von Bedeutung, wobei sich farbliche Unregelmäßigkeiten im emittierten Scheinwerferkegel störend auswirken können.

Es ist eine Aufgabe, ein Gehäuse der eingangs genannten Art anzugeben, mit dem auf technische einfache Weise unter Verwendung eines Lumineszenzkonversionsmaterials ein Lumineszenzdioden-Bauelement mit geringen Farbinhomogenitäten eines emittierten Lichtkegels realisierbar ist. Das Gehäuse soll dabei insbesondere auch für Scheinwerfer- oder Projektionsapplikationen geeignet sein. Zudem soll ein Bauelement mit einem derartigen Gehäuse und entsprechenden Eigenschaften angegeben werden.

Es wird ein Gehäuse angegeben, dessen Gehäusekavität mindestens einen Teilbereich aufweist, der lateral von einem die Gehäusekavität seitlich begrenzenden Gehäusematerial überdeckt ist. Bevorzugt ist der Teilbereich auch lateral zur Ausgangsöffnung versetzt. Unter lateral ist eine Richtung parallel zu einer Chipmontageebene des Chipmontagebereiches zu verstehen.

Der Teilbereich der Gehäusekavität ist durch Gehäusematerial abgeschattet. Es kann dadurch unter Verwendung eines Lumineszenzkonversionsmaterials ein Bauelement mit einer hohen Farbhomogenität auf technisch einfache Weise realisiert werden. Zudem kann das Abschatten des Teilbereiches dazu dienen, eine gewünschte Leuchtdichteverteilung des von dem herzustellenden Bauelements emittierten Lichtkegel einzustellen. Insbesondere unsymmetrische Leuchtdichteverteilung können so mit Vorteil realisiert werden.

Zweckmäßigerweise grenzt der lateral überdeckte Teilbereich der Gehäusekavität an eine Chipmontageebene des Gehäuses an.

Es wird ein Gehäuse für ein Lumineszenzdioden-Bauelement der eingangs genannten Art angegeben, das zumindest in einem vertikalen Abstand zum Chipmontagebereich Innenwände aufweist, die die Gehäusekavität seitlich umgrenzen und einen maximalen lateralen Abstand von kleiner als oder gleich 500 µm zu dem Chipmontagebereich aufweisen. Das Gehäuse kann zusätzlich eines oder mehrere der vorhergehend oder nach folgend beschriebenen Merkmale aufweisen.

Insbesondere umschließen die Innenwände die Gehäusekavität seitlich. Mit anderen Worten weist die Gehäusekavität in einem Abstand zum Chipmontagebereich einen in lateraler Richtung sehr engen Abschnitt auf, dessen laterale Ausdehnung nicht sehr viel größer ist als der Chipmontagebereich, das heißt als die laterale Ausdehnung des für das Gehäuse vorgesehenen Lumineszenzdiodenchips.

In dem Fall, dass mehrere Chipmontagebereiche in einer linienförmigen Anordnung in dem Gehäuse vorhanden sind und die Gehäusekavität in einer Draufsicht eine gestreckte Form aufweist, so ist es ausreichend, wenn die Innenwände nur an den Längsseiten die angegebenen maximalen Abstände zu einem nächsten Chipmontagebereich aufweisen. Die Innenwände an den Querseiten können auch einen größeren lateralen Abstand zu dem nächstliegenden Chipmontagebereich aufweisen.

Es wurde festgestellt, dass durch eine derartige Gestaltung des Gehäuses oder der Gehäusekavität auch dann Lumineszenzdioden-Bauelemente mit einer geringen Farbinhomogenität realisierbar sind, wenn die Gehäusekavität nicht nur mit einem Lumineszenzkonversionsmaterial in Form einer dünnen, gleichmäßigen Schicht versehen ist, sondern wenn sie mit einem Lumineszenzkonversionsmaterial in Form eines Volumenvergusses gefüllt ist. Der Verguss kapselt den Lumineszenzdiodenchip insbesondere ein.

Zudem wurde festgestellt, dass derartige Gehäuse eine gute Eignung für Scheinwerferapplikationen haben können, insbesondere wenn inhomogene Lichtdichteverteilungen zu realisieren sind. Es können mit dem Gehäuse demnach insbesondere Bauelemente mit einem Lumineszenzkonversionsmaterial erzeugt werden, die sowohl eine hohe Farbhomogenität aufweisen, als auch vorgegebene inhomogene Lichtdichteverteilungen eines zu erzeugenden Lichtkegels mit Vorteil ermöglichen.

Die Innenwände der Gehäusekavität verlaufen zumindest im Bereich des engen Abschnitts bevorzugt im Wesentlichen senkrecht zur Chipmontageebene.

Die Innenwände weisen den geringen lateralen Abstand zu dem Chipmontagebereich mindestens in einem vertikalen Abstand von größer als oder gleich 300 µm, bevorzugt von größer als oder gleich 500 µm von der Chipmontageebene auf. Gemäß einer besonders bevorzugten Ausführungsform weist eine die Ausgangsöffnung umgrenzende Kante des Gehäuses einen maximalen lateralen Abstand von kleiner als oder gleich 500 µm zu dem Chipmontagebereich auf.

Der maximale laterale Abstand der Innenwände oder der Kante zu dem Chipmontagebereich beträgt besonders bevorzugt weniger als oder gleich 350 µm. Entlang mindestens einer Hauptseite beträgt dieser laterale Abstand der Innenwände oder der Kante mit Vorteil maximal 200 µm, bevorzugt maximal 150 µm zu dem Chipmontagebereich. Ein Gehäuse weist in der Regel vier Hauptseiten auf, insbesondere ein Gehäuse mit einer z.B. im wesentlichen quadratischen oder rechteckigen Form.

Gemäß einer bevorzugten Ausführungsform ist in der Gehäusekavität eine elektrische Kontaktfläche zum elektrisch leitfähigen Kontaktieren eines Lumineszenzdiodenchips enthalten, die zumindest teilweise von dem die Gehäusekavität seitlich begrenzenden Gehäusematerial überdeckt ist. Derartige elektrische Kontaktflächen können insbesondere dazu dienen, Lumineszenzdiodenchips mittels eines Bonddrahtes elektrisch leitend zu kontaktieren. Durch eine zumindest teilweise Anordnung der elektrischen Kontaktfläche in dem überdeckten Bereich kann der zur Verfügung stehende Platz in der Gehäusekavität geschickt ausgenutzt und eine kleine laterale Ausdehnung der übrigen Gehäusekavität realisiert werden.

Gemäß einer weiteren vorteilhaften Ausführungsform ist zusätzlich oder alternativ ein Teil des Chipmontagebereichs lateral von dem die Gehäusekavität seitlich begrenzenden Gehäusematerial überdeckt. Unter dem Chipmontagebereich ist im Zusammenhang der vorliegenden Anmeldung ein Bereich zu verstehen, der dafür vorgesehen ist, in einem Bauelement von einem Lumineszenzdiodenchip ausgefüllt zu sein. Eine partielle Überdeckung des Chipmontagebereichs hat somit auch eine partielle Überdeckung eines Lumineszenzdiodenchips in dem herzustellenden Bauelement zur Folge, sodass in der Regel auch ein Teil der Licht emittierenden Fläche des Lumineszenzdiodenchips in dem Bauelement lateral abgeschattet ist. Dadurch ist ein Lichtkegel realisierbar, der auf der Seite, an der der Lumineszenzdiodenchip partiell abgeschattet ist, eine besonders hohe Leuchtdichte und insbesondere einen sehr steilen Leuchtdichtegradienten aufweist. Dies ist insbesondere bei Scheinwerferapplikationen für Kraftfahrzeuge von Vorteil.

Bevorzugt weist das Gehäuse mehrere Chipmontagebereiche auf, die in einer linienförmigen Anordnung zueinander angeordnet sind. Zweckmäßigerweise ist die Kavität hierbei grabenartig ausgebildet und weist insbesondere in einer Draufsicht eine gestreckte Form auf. Mit einem derartig ausgebildeten Gehäuse ist ein Bauelement realisierbar, das einen für viele Anwendungen vorteilhaften Strahlungskegel emittiert. Der Strahlungskegel kann einen Querschnitt mit einer relativ großen Länge und einer verglichen damit kleinen Breite aufweisen, was zum Beispiel für die Anwendung in Autoscheinwerfern vorteilhaft ist, bei denen vertikal ein relativ kleiner Raumwinkel, horizontal jedoch die Fahrbahn in ihrer vollen Breite, das heißt ein relativ großer Raumwinkel ausgestrahlt werden soll.

Das Gehäuse weist mit Vorteil einen die Gehäusekavität seitlich begrenzenden Rahmen auf, der lichtdicht ausgebildet ist und insbesondere aus einem lichtdichten Material besteht. Besonders bevorzugt weist das Gehäuse jedoch alternativ zu dieser Ausführungsform einen die Gehäusekavität seitlich begrenzenden Rahmen auf, der zumindest teilweise lichtdurchlässig ist. Dadurch kann erreicht werden, dass über den Gehäuserahmen ebenfalls ein Teil des im Gehäuse erzeugten Lichts emittiert wird, sodass auch bei einer relativ engen Gehäusekavität ein Bauelement mit einem Strahlungskegel realisierbar ist, der relativ sanfte Hell-Dunkel-Übergänge aufweist.

Zweckmäßigerweise weist der Rahmen in lateraler Richtung eine Transmissionsfähigkeit für Licht von größer als oder gleich 20 % auf. Zusätzlich oder alternativ ist die Transmissionsfähigkeit des Rahmens mit Vorteil kleiner als oder gleich 80 %. Gemäß einer weiteren zweckmäßigen Ausbildung weist das Gehäuse einen Gehäuseteil auf, der einen Teilbereich der Gehäusekavität lateral überdeckt und der in vertikaler Richtung eine Transmissionsfähigkeit für Licht von größer als oder gleich 20 % und/oder kleiner als oder gleich 80 % aufweist. Grundsätzlich ist es auch möglich, ein nahezu vollständig lichtdurchlässiges Material wie beispielsweise lichtdurchlässiges Glas für den Rahmen zu verwenden, so dass der Rahmen in lateraler Richtung eine Transmissionsfähigkeit für Licht von größer als 80 % aufweist.

Die vorliegende Erfindung sieht vor, dass eine Außenfläche des Gehäuses, die an die Ausgangsöffnung der Gehäusekavität grenzt, mit einer Abschirmschicht versehen ist. Die Abschirmschicht ist geeignet, eine elektromagnetische Strahlung abzuschirmen, wobei vorgesehen ist, eine im Inneren des Gehäuses erzeugte oder zu erzeugende elektromagnetische Strahlung nach außen abzuschirmen. Dadurch kann bei entsprechenden optoelektronischen Bauelementen mit einem derartigen Gehäuse vorteilhafterweise ein Austritt elektromagnetischer Strahlung aus dem Gehäuse in unerwünschte Raumwinkel deutlich verringert oder vollständig vermieden werden.

Mit der Abschirmschicht lässt sich insbesondere bei Verwendung eines lichtdurchlässigen Rahmens ein Gehäuse mit einer gezielten Lichtabschattung realisieren. Mit einem derartigen Gehäuse lässt sich ein Strahlungskegel erzeugen, dessen Querschnitt auf zumindest einer Seite einen abrupten Hell-Dunkel-Übergang aufweist.

Die Abschirmschicht ist dazu geeignet, eine elektromagnetische Strahlung abzuschirmen, die einen Spektralbereich einer von einem Lumineszenzdiodenchip emittierten elektromagnetischen Strahlung umfasst, wobei der Lumineszenzdiodenchip für ein Bauelement mit dem Gehäuse vorgesehen ist.

Besonders bevorzugt ist die Abschirmschicht geeignet, eine elektromagnetische Strahlung vollständig abzuschirmen, das heißt die Abschirmschicht ist besonders bevorzugt undurchlässig für eine elektromagnetische Strahlung eines abzuschirmenden Wellenlängenbereiches. Der abzuschirmende Wellenlängenbereich kann insbesondere der gesamte Wellenlängenbereich einer von einem Bauelement, das mit dem Gehäuse herzustellen ist, emittierten elektromagnetischen Strahlung sein. Es ist jedoch auch möglich, dass die Abschirmschicht auch teilweise durchlässig für elektromagnetische Strahlung ist. Beispielsweise kann sie für elektromagnetische Strahlung eines nicht notwendigerweise abzuschirmenden Wellenlängenbereiches oder auch für eine abzuschirmende elektromagnetische Strahlung teilweise durchlässig sein. Die abzuschirmende elektromagnetische Strahlung ist bevorzugt sichtbares Licht.

Bevorzugt weist die Abschirmschicht für einen abzuschirmenden Wellenlängenbereich einer elektromagnetischen Strahlung, die von einem Bauelement mit dem Gehäuse emittiert wird, einen Gesamttransmissionsgrad von kleiner als oder gleich 0,2, besonders bevorzugt von kleiner als oder gleich 0,1 auf. Mit besonderem Vorteil ist dieser Gesamttransmissionsgrad zumindest für den sichtbaren Anteil der Strahlung ungefähr 0. Unter dem Begriff "Abschirmschicht" fallen vorliegend keine elektrischen Anschlussleiter oder elektrische Leiterbahnen des Gehäuses. Vielmehr ist das Gehäuse auf der Außenfläche entweder frei von elektrischen Leiterbahnen oder elektrischen Anschlussleitern oder das Gehäuse weist an der Außenfläche zusätzlich zu etwaigen vorhandenen elektrischen Anschlussleitern oder elektrischen Leiterbahnen mindestens eine Abschirmschicht auf.

Die Außenfläche des Gehäuses weist mit Vorteil eine von der Gehäusekavität abgewandte Teilfläche auf, die mit der Abschirmschicht versehen ist. Die Teilfläche verläuft zweckmäßigerweise schräg zu einer Chipmontageebene des Gehäuses.

Ein an die Ausgangsöffnung angrenzender Teil der Außenfläche ist frei von der Abschirmschicht , sodass mit dem Gehäuse ein Strahlungskegel realisierbar ist, dessen Querschnitt sowohl abrupte als auch sanfte Hell-Dunkel-Übergänge aufweist. Derartige Eigenschaften eines Strahlungskegels sind insbesondere bei Kfz-Scheinwerfern von Bedeutung, bei denen nach oben hin ein relativ abrupter Hell-Dunkel-Übergang des Strahlungskegels gefordert wird und nach unten oder zur Seite ein verglichen damit eher sanfterer Übergang vom Hellen zum Dunklen vorteilhaft ist.

Die Gehäusekavität weist mit besonderem Vorteil eine geringe Tiefe auf. Bevorzugt ist die Tiefe der Gehäusekavität kleiner als oder gleich 500 µm.

Zusätzlich oder alternativ weist ein die Gehäusekavität seitlich umgebender Gehäuserahmen eine relativ geringe Dicke in lateraler Richtung auf, die bevorzugt kleiner als oder gleich 1,5 mm, besonders bevorzugt kleiner als oder gleich 1,1 mm ist. Der Gehäuserahmen weist mit besonderem Vorteil Teilbereiche auf, in denen er in lateraler Richtung eine Dicke von kleiner als oder gleich 0,7 mm aufweist.

Gemäß einer besonders zweckmäßigen Ausführungsform ist das Gehäuse für ein Scheinwerfer-Bauelement geeignet, insbesondere für ein Kfz-Scheinwerfer-Bauelement.

Es wird ein Lumineszenzdioden-Bauelement angegeben, welches das Gehäuse sowie mindestens einen Lumineszenzdiodenchip aufweist, der auf dem Chipmontagebereich montiert ist. Zweckmäßigerweise sind ebenso viele Lumineszenzdiodenchips wie Chipmontagebereiche in dem Gehäuse enthalten.

Bevorzugt ist in der Gehäusekavität ein Lumineszenzkonversionsmaterial angeordnet, das mindestens einen Leuchtstoff aufweist, der durch eine von dem Lumineszenzdiodenchip emittierte elektromagnetische Strahlung anregbar ist. Besonders bevorzugt ist der Leuchtstoff in eine Vergussmasse gemischt, die wiederum in die Gehäusekavität gefüllt ist. Die Vergussmasse füllt die Gehäusekavität zumindest teilweise.

Gemäß einer besonders zweckmäßigen Ausführungsform ist das Lumineszenzdioden-Bauelement ein Scheinwerfer-Bauelement, insbesondere für ein Kraftfahrzeug.

Die vorliegende Erfindung ist in dem unabhängigen Anspruch 1 definiert.

Weitere Vorteile, bevorzugte Ausführungsformen und Weiterbildungen des Gehäuses und des Bauelements ergeben sich aus den im Folgenden in Verbindung mit den Figuren 1 bis 6 erläuterten Ausführungsbeispielen. Es zeigen:
- Figur 1: eine schematische Draufsicht eines ersten Ausführungsbeispiels des Bauelements und des Gehäuses,
- Figur 2: eine schematische Schnittansicht des in Figur 1 dargestellten Bauelements und Gehäuses,
- Figur 3: eine schematische Draufsicht eines zweiten Ausführungsbeispiels des Bauelements und des Gehäuses,
- Figur 4: eine schematische Schnittansicht des in Figur 3 dargestellten Bauelements und Gehäuses,
- Figur 5: eine schematische Draufsicht eines dritten Ausführungsbeispiels des Bauelements und des Gehäuses, und
- Figur 6: eine schematische Schnittansicht des in Figur 5 dargestellten Bauelements und Gehäuses.

In den Ausführungsbeispielen und Figuren sind gleiche oder gleich wirkende Bestandteile jeweils mit den gleichen Bezugszeichen versehen. Die dargestellten Elemente der Figuren sind nicht notwendigerweise als maßstabsgerecht anzusehen, vielmehr können sie zum besseren Verständnis teilweise übertrieben groß dargestellt sein.

Die in den Figuren dargestellten Lumineszenzdioden-Bauelemente 2 weisen jeweils ein Gehäuse 1 mit einer Gehäusekavität 11 auf, in der entsprechend der vorhandenen Anzahl von Chipmontagebereichen 33 jeweils Lumineszenzdiodenchips 3 mechanisch und elektrisch leitend montiert sind. Jedes Bauelement 2 weist beispielsweise 5 Lumineszenzdiodenchips 3 auf.

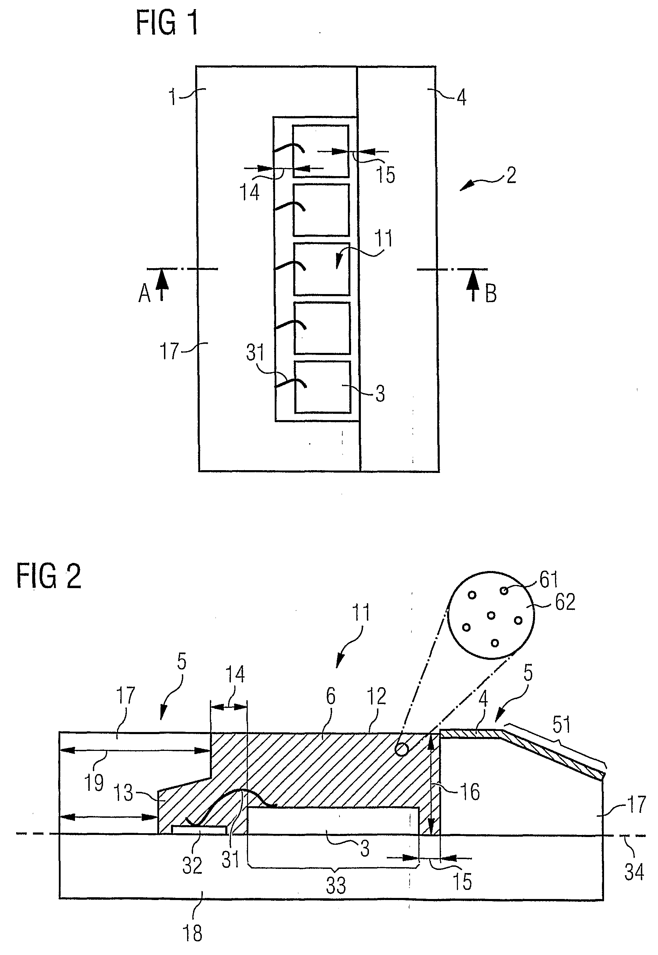

In den Figuren 2, 4 und 6 sind jeweils schematische Schnittansichten der in den Figuren 1, 3 und 5 in einer Draufsicht dargestellten Bauelemente gezeigt. Der Schnitt für die Schnittansichten verläuft entlang der in den Figuren 1, 3 und 5 jeweils dargestellten Linie AB.

Bei den Bauelementen gemäß den Ausführungsbeispielen weisen die Gehäusekavitäten 11 jeweils eine Ausgangsöffnung 12 auf. Die Gehäusekavitäten sind vollständig, das heißt bis zur Ausgangsöffnung 12 hin mit einem Lumineszenzkonversionsmaterial 6 gefüllt. Alternativ können die Gehäusekavitäten 11 auch nur teilweise mit einem Lumineszenzkonversionsmaterial 6 gefüllt sein, sodass dieses nicht bis zur Ausgangsöffnung 12 der Gehäusekavität 11 heranreicht.

Das Lumineszenzkonversionsmaterial weist eine Vergussmasse 62 auf. Diese basiert beispielsweise auf einem Epoxidharz, auf einem Silikon oder auf einem Hybridmaterial mit mindestens zwei Komponenten, in dem ein Epoxidharz und/oder ein Silikon enthalten ist. Die Vergussmasse 62 ist mit mindestens einem Leuchtstoff 61 vermischt. Der Leuchtstoff ist beispielsweise durch blaues Licht anregbar und emittiert ein gelbes Licht.

Als Leuchtstoff eingnet sich zum Beispiel ein mit Ce aktivierter Granatleuchtstoff, beispielsweise mit Ce aktiviertes Tb₃Al₅O₁₂ oder mit Ce aktiviertes Y₃Al₅O₁₂. Grundsätzlich eignen sich alle organischen und anorganischen Leuchtstoffe, die für eine Verwendung in Kombination mit Lumineszenzdiodenchips bekannt sind. Es können auch mehrere Leuchtstoffe verwendet werden, wobei es nicht nur möglich ist, dass die mehreren Leuchtstoffe unterschiedliche Farben emittieren, sondern auch, dass die Leuchtstoffe unterschiedliche Farbtöne derselben Farbe emittieren. Beispielsweise sind mehrere Leuchtstoffe enthalten, die verschiedene Gelbtöne emittieren. Die Emissionsspektren der Leuchtstoffe können folglich mit Vorteil überlappen.

Die Lumineszenzdiodenchip sind beispielsweise Halbleiterleuchtdidodenchips. Sie basieren beispielsweise auf Nitrid-Verbindungshalbleitermaterialien. Darunter sind Verbindungshalbleitermaterialien zu verstehen, die Stickstoff enthalten, wie z.B. Materialien aus dem System InₓAl_{y}Ga_{1-x-y}N mit 0 ≤ x ≤ 1, 0 ≤ y ≤ 1 und x+y ≤ 1. Die Lumineszenzdiodenchips weisen zweckmäßigerweise eine epitaktisch gewachsenen Halbleiterschichtenfolge auf, die mindestens eine Einzelschicht mit einem Nitrid-Verbindungshalbleitermaterial enthält. Die Halbleiterschichtenfolge kann beispielsweise einen herkömmlichen pn-Übergang, eine Doppelheterostruktur, eine Einfach-Quantentopfstruktur (SQW-Struktur) oder eine Mehrfach-Quantentopfstruktur (MQW-Strukur) aufweisen. Solche Strukturen sind dem Fachmann bekannt und werden von daher an dieser Stelle nicht näher erläutert.

Alternativ können die Lumineszenzdiodenchips 3 auch auf einem anderen Materialsystem basieren. Es können grundsätzlich auch organische Leuchtdioden in dem Bauelement verwendet werden.

Die Gehäuse weisen in allen Ausführungsbeispielen eine Träger 18 auf. Bei den in den Figuren 1 bis 4 dargestellten Ausführungsbeispielen sind die Lumineszenzdiodenchips 3 mit ihrer zu dem Gehäuseträger 18 gewandten Seite beispielsweise mittels eines elektrisch leitfähigen Klebstoffes oder mittels eines Lotes mechanisch und elektrisch leitend montiert. In diesen Ausführungsbeispielen weisen die Lumineszenzdiodenchips 3 auch auf ihrer der Ausgangsöffnung 12 zugewandten Seite eine elektrische Kontaktfläche auf (nicht gezeigt). Diese elektrische Kontaktfläche ist mittels eines Bonddrahtes 31 mit einer entsprechenden elektrischen Kontaktfläche 32 des Gehäuses 1 elektrisch leitend verbunden.

Die elektrische Kontaktfläche 32 ist auf dem Boden der Gehäusekavität 11 angeordnet. Sie grenzt an den Gehäuseträger 18, auf dem ein Gehäuserahmen 17 aufgebracht ist. Der Gehäuseträger 18 und der Gehäuserahmen 17 bestehen jeweils aus einem separaten Teil, sie können jedoch alternativ auch aus einem einzigen Teil gemeinsam ausgebildet sein.

Bei dem in Figur 2 dargestellten Ausführungsbeispiel überragt ein Teil des Rahmens einen Teilbereich 13 der Gehäusekavität 11 lateral. Dieser Rahmenteil überragt auch einen Teil der elektrischen Anschlussfläche 32 lateral. Der von dem Gehäuserahmen lateral überragte Teilbereich 13 und der entsprechende Teil der elektrischen Anschlussfläche 32 sind auch lateral zu der Ausgangsöffnung 12 der Gehäusekavität 11 versetzt.

Der übrige Teil der Gehäusekavität 11 überlappt vollständig lateral mit der Ausgangsöffnung 12. Er grenzt an Innenwände des Gehäuserahmens, die im Wesentlichen senkrecht zu einer Chipmontageebene 34 des Gehäuses 1 verlaufen. Diese Innenwände der Gehäusekavität weisen zu dem Chipmontagebereich 33 einen maximalen lateralen Abstand 14 von beispielsweise 350 µm auf. Der maximale laterale Abstand 14 zu den Chipmontagebereichen 33 ist gleich dem maximalen Abstand 14 zu den Lumineszenzdiodenchips 3.

Die Innenwände weisen zu den Chipmontagebereichen 33 und den Lumineszenzdiodenchips 3 einen minimalen Abstand 15 von beispielsweise 150 µm auf. Alternativ kann der minimale Abstand beispielsweise etwa nur 50 µm groß sein. Die Gehäusekavität weist beispielsweise eine Tiefe 16 von nur 500 µm auf.

Der Gehäuserahmen 17 besteht beispielsweise aus einem Material, das nicht durchsichtig aber für sichtbares Licht durchlässig ist. In den dicksten Bereichen weist der Gehäuserahmen 17 beispielsweise in lateraler Richtung eine Transmission für Licht von etwa 40 % auf. Die maximale Dicke 19 des Gehäuserahmens beträgt in lateraler Richtung zum Beispiel 1,05 mm. Der Teil des Gehäuserahmens 17, der den Teilbereich 13 der Gehäusekavität lateral überragt, weist in vertikaler Richtung beispielsweise eine Transmission für sichtbares Licht von etwa 70 % auf.

An den dünnsten Stellen weist der Gehäuserahmen 17 in lateraler Richtung eine Dicke 190 von beispielsweise etwa 500 µm auf.

Der Gehäuserahmen 17 besteht beispielsweise aus einem keramischen Material oder weist ein solches Material auf. Ein geeignetes Material ist zum Beispiel Aluminiumoxid (Al₂O₃). Alternativ weist der Rahmen 17 beispielsweise Aluminiumnitrid, Glaskeramik, Glas oder mindestens einen Kunststoff auf.

Der Rahmen 17 kann insbesondere aus einem Kunststoff bestehen oder einen solchen Kunststoff aufweisen, der einen ähnlichen thermischen Ausdehnungskoeffizienten wie ein Material des Trägers 18 aufweist. Der Gehäuseträger 18 kann zum Beispiel auch Metall aufweisen oder aus einem solchen bestehen. Ein gute Eignung weist beispielsweise Kupfer aufgrund seiner hohen Wärmeleitfähigkeit auf. Alternativ kann der Gehäuseträger 18 beispielsweise aus demselben Material bestehen wie der Gehäuserahmen 17.

Die Lumineszenzdiodenchips 3 sind in einer linienförmigen Anordnung in dem Gehäuse 1 montiert. Die Anordnung verläuft entlang einer Gerade. Alternativ kann die linienförmige Anordnung auch entlang einer beliebig geformten Linie verlaufen, beispielsweise entlang einer gekrümmten oder einer geknickten Linie. Mit besonderem Vorteil sind die Lumineszenzdiodenchips entlang einer Linie angeordnet, die einen Knick aufweist, wobei die zueinander geneigten Linienstücke einen Winkel von etwa 165° zueinander aufweisen. Mit anderen Worten umfasst die Linie zwei Teilgeraden, die um etwa 15° zueinander geneigt sind.

Auf einer an die Ausgangsöffnung 12 der Gehäusekavität 11 angrenzenden Außenfläche 5 ist der Gehäuserahmen mit einer Abschirmschicht 4 versehen. Die Abschirmschicht 4 ist auf einer Seite der Außenfläche 5 des Gehäuserahmens 17 enthalten. Auf einer dieser Seite gegenüberliegenden Seite des Gehäuserahmens ist die Außenfläche 5 frei von der Abschirmschicht 4.

Die mit der Abschirmschicht 4 versehene Außenfläche 5 weist eine Teilfläche 51 auf, die von der Gehäusekavität 11 abgeneigt ist. Bevorzugt ist diese Teilfläche auch von der Gehäusekavität beabstandet. Eine derartige Ausführung ist sowohl für das Aufbringen der Abschirmschicht als auch für die durch die Abschirmschicht erzielte Abschirmwirkung vorteilhaft.

Die Abschirmschicht 4 besteht beispielsweise aus einem reflektierenden Material, das zum Beispiel metallisches Material wie Silber aufweist. Zum Ausbilden der Abschirmschicht ist z.B. eine Silberschicht mit einer ausreichend hohen Schichtdicke auf den entsprechenden Flächen des Gehäuses aufgebracht. Silber weist für einen großen Spektralbereich sichtbaren Lichts eine hohe Reflektivität auf. Die Silberschicht kann lediglich wenige Monolagen dick sein, damit sie gezielt noch teilweise für elektromagnetische Strahlung durchlässig ist. Um eine vollständige Abschirmung zu erzielen, muss die Dicke signifikant größer sein. Hierzu weist sie beispielsweise eine Dicke von 10 µm auf.

Zusätzlich oder alternativ kann die Abschirmschicht 4 beispielsweise auch absorbierendes Material aufweisen. Hierfür kommt zum Beispiel ebenfalls metallisches Material in Frage, das für einen vorgesehenen Spektralbereich überwiegend absorbierende Eigenschaften aufweist. Auch bei dem absorbierenden Material ist es wichtig, dieses nicht in einer zu dünnen Schicht aufzutragen, wenn eine im Inneren des Gehäuses erzeugte elektromagnetische Strahlung weitestgehend abgeschirmt werden soll. Die Abschirmschicht weist für einen abzuschirmenden Wellenlängenbereich beispielsweise einen Gesamttransmissionsgrad von kleiner als oder gleich 0,05 auf. Als absorbierendes Material kommen beispielsweise auch Lacke oder Kunststoffe in Frage.

Die Abschirmschicht 3 weist gemäß einer weiteren beispielhaften Ausführungsform eine reflektierende Schicht auf, die auf der Außenfläche 5 aufgebracht ist und auf der wiederum eine absorbierende Schicht aufgebracht ist. Die absorbierende Schicht ist beispielsweise ein schwarzer Lack oder ein schwarzer Kunststoff. Diese sind insbesondere für sichtbare elektromagnetische Strahlung absorbierend. Die Abschirmschicht 3 kann alternativ beispielsweise auch nur aus einer ausreichend dicken schwarzen Lackschicht oder schwarzen Kunststoffschicht bestehen.

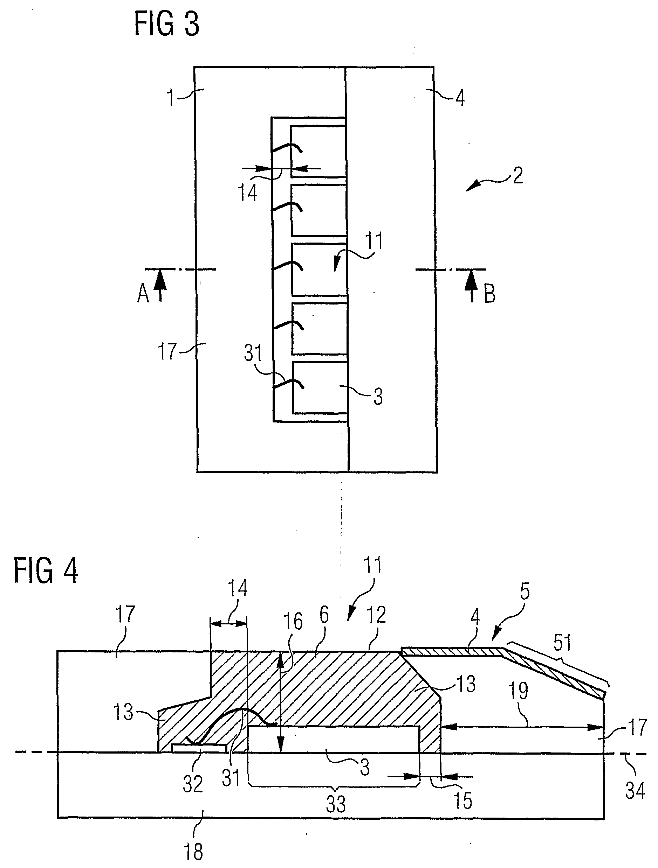

Bei dem in den Figuren 3 und 4 dargestellten Ausführungsbeispiel weist die Gehäusekavität 11 zwei Teilbereiche 13 auf, die lateral von Gehäusematerial überdeckt sind. In einem dieser Teilbereiche 13 ist ein Teil des Lumineszenzdiodenchips 3 angeordnet, so dass entsprechend auch ein Teil des Chipmontagebereiches 33 lateral von Gehäusematerial überdeckt ist. Dieser Teilbereich 13 und der Teil des Lumineszenzdiodenchips oder des Chipmontagebereichs 33 sind in dem dargestellten Ausführungsbeispiel zudem auch von der Abschirmschicht 4 lateral überdeckt.

Ein Teil der Gehäusekante, die die Ausgangsöffnung 12 umgrenzt, überlappt vollständig mit dem Chipmontagebereich 33, d.h. er ist über dem Chipmontagebereich 33 angeordnet. Ein weiterer Teil dieser Kante weist einen maximalen Abstand 14 von beispielsweise 300 µm zu dem Chipmontagebereich 33 oder dem Lumineszenzdiodenchip 3 auf.

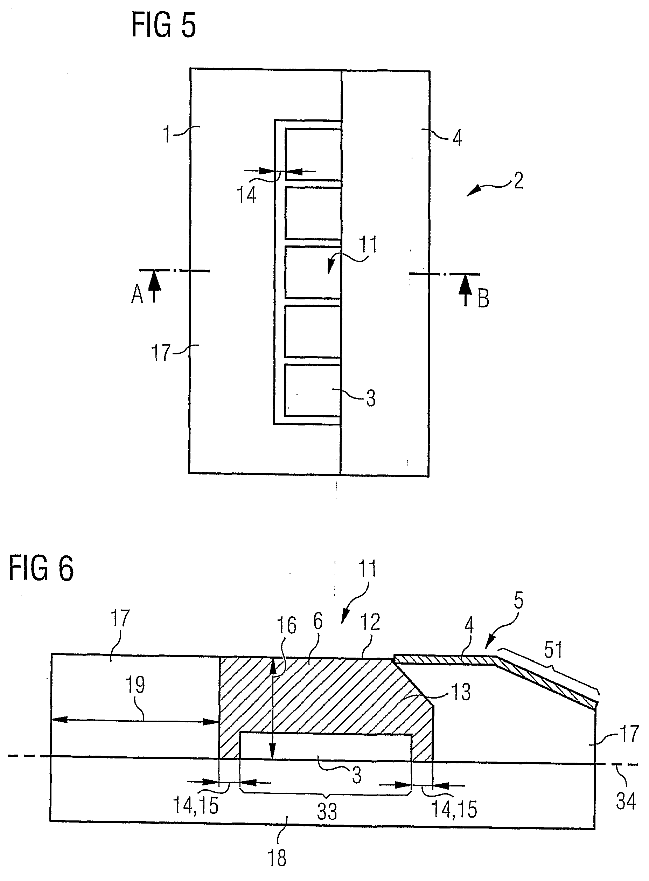

Bei dem in den Figuren 5 und 6 dargestellten Ausführungsbeispiel ist der Chipmontagebereich 33 ebenfalls teilweise von einem Teil des Rahmens lateral überdeckt. Im Unterschied zu den anhand der Figuren 1 bis 4 beschriebenen Ausführungsbeispielen weist das in den Figuren 5 und 6 dargestellte Gehäuse keine elektrische Anschlussfläche 32 auf, die neben dem Chipmontagebereich 33 angeordnet ist. Auf der entsprechenden Seite ist die Innenwand der Gehäusekavität 11 gerade ausgebildet und verläuft im Wesentlichen senkrecht zur Chipmontageebene 34. Bei dieser Ausführungsform kann der maximale Abstand 14 zum Lumineszenzdiodenchip 3 noch kleiner gewählt werden. Er beträgt beispielsweise 150 µm oder 100 µm.

Diese in den Figuren 5 und 6 dargestellte Ausführungsform eignet sich insbesondere für Lumineszenzdiodenchips, die beide elektrische Anschlüsse auf derselben Seite aufweisen, wie das beispielsweise bei so genannten Flip-Chips der Fall ist. Bei derartigen Lumineszenzdiodenchips 3 können beide elektrischen Anschlüsse unmittelbar mit entsprechenden elektrischen Anschlüssen auf dem Chipträger 18, die innerhalb des Chipmontagebereichs 33 angeordnet sind und auf dem der Lumineszenzdiodenchip 3 aufliegt, elektrisch leitend verbunden werden. Die Gehäusekavität kann somit insgesamt entlang der Chipmontageebene 34 noch enger ausgebildet werden.

Der Schutzumfang der Erfindung ist nicht durch die Beschreibung der Erfindung anhand der Ausführungsbeispiele auf diese beschränkt. So ist es zum Beispiel nicht zwingend erforderlich, mehrere Lumineszenzdiodenchips in einer einzigen Reihe anzuordnen. Vielmehr ist es auch möglich, diese zum Beispiel in zwei oder noch mehr Reihen anzuordnen.

## Patentansprüche

1. Lumineszenzdioden-Bauelement (2), umfassend ein Gehäuse (1) mit einer Gehäusekavität (11), innerhalb der mindestens ein Chipmontagebereich (33) für einen Lumineszenzdiodenchip (3) angeordnet ist und die eine Ausgangsöffnung (12) aufweist, und mit einem Lumineszenzdiodenchip (3), der auf dem Chipmontagebereich (33) montiert ist, wobei
- das Gehäuse (2) zumindest in einem vertikalen Abstand zum Chipmontagebereich (33) Innenwände aufweist, die die Gehäusekavität (11) seitlich umgrenzen und in einer lateralen Richtung, die parallel zu einer Chipmontageebene (34) des Chipmontagebereichs (33) verläuft, einen maximalen Abstand von kleiner als oder gleich 500 µm zu dem Chipmontagebereich (33) aufweisen, und - ein erster Teil einer Außenfläche (5) des Gehäuses (1), die an die Ausgangsöffnung (12) der Gehäusekavität (11) grenzt, mit einer Abschirmschicht (4) versehen ist, die geeignet ist, einen Spektralbereich der von dem Lumineszenzdiodenchip (3) emittierten elektromagnetischen Strahlung abzuschirmen,
**dadurch gekennzeichnet, dass**
- ein zweiter Teil der an die Ausgangsöffnung (12) angrenzenden Außenfläche (5) frei von der Abschirmschicht (4) ist.

2. Lumineszenzdioden-Bauelement nach Anspruch 1,
**dadurch gekennzeichnet, dass**
die Gehäusekavität (11) mindestens einen Teilbereich aufweist, der von einem die Gehäusekavität (11) seitlich begrenzenden Gehäusematerial lateral überdeckt ist.

3. Lumineszenzdioden-Bauelement nach einem der vorhergehenden Ansprüche,
**dadurch gekennzeichnet, dass**
eine elektrische Kontaktfläche : (32) zum elektrisch leitfähigen Kontaktieren des Lumineszenzdiodenchips (3) innerhalb der Gehäusekavität (11) enthalten ist, wobei zumindest ein Teil der elektrischen Kontaktfläche (32) von einem die Gehäusekavität (11) 5 seitlich begrenzenden Gehäusematerial lateral überdeckt ist.

4. Lumineszenzdioden-Bauelement nach einem der vorhergehenden Ansprüche,
**dadurch gekennzeichnet, dass**
ein Teil des Chipmontagebereichs (33) lateral zur Ausgangsöffnung (12) versetzt ist.

5. Lumineszenzdioden-Bauelement nach einem der vorhergehenden Ansprüche,
**dadurch gekennzeichnet, dass**
mehrere Chipmontagebereiche (33) enthalten sind, die in einer linienförmigen Anordnung zueinander angeordnet sind.

6. Lumineszenzdioden-Bauelement nach einem der vorhergehenden Ansprüche,
**dadurch gekennzeichnet, dass**
ein die Gehäusekavität (11) seitlich begrenzender Rahmen (17) enthalten ist, der zumindest teilweise lichtdurchlässig ist.

7. Lumineszenzdioden-Bauelement nach einem der vorhergehenden Ansprüche,
**dadurch gekennzeichnet, dass**
die Gehäusekavität (11) eine Tiefe von kleiner als oder gleich 500 µm aufweist.

8. Lumineszenzdioden-Bauelement nach einem der vorhergehenden Ansprüche,
**dadurch gekennzeichnet, dass**
ein in die Gehäusekavität (11) seitlich umgebender Gehäuserahmen (17) in der lateralen Richtung eine Dicke von kleiner als oder gleich 1,5 mm aufweist.

9. Lumineszenzdioden-Bauelement gemäß Anspruch 8,
**dadurch gekennzeichnet, dass**
in der Gehäusekavität (11) ein Lumineszenzkonversionsmaterial angeordnet ist, das mindestens einen durch eine von dem Lumineszenzdiodenchip (3) emittierte elektromagnetische Strahlung anregbaren Leuchtstoff (61) aufweist.

## Claims

1. Luminescence diode component (2),
comprising a housing (1) having a housing cavity (11), within which at least one chip mounting region (33) for a luminescence diode chip (3) is arranged and which has an output opening (12) and having a luminescence diode chip (3) mounted on the chip mounting region (33),
wherein
- the housing (2) has, at least at a vertical distance from the chip mounting region (33), inner walls which laterally bound the housing cavity (11) and in a lateral direction running parallel to a chip mounting plane (34) of the chip mounting region (33), are at a maximum distance of less than or equal to 500 µm from the chip mounting region (33), and
- a first part of an outer surface (5) of the housing (1) which adjoins the output opening (12) of the housing cavity (11) is provided with a shielding layer (4) suitable for shielding a spectral range of the electromagnetic radiation emitted by the luminescence diode chip (3),
**characterized in that**
- a second part of the outer surface (5) which adjoins the output opening (12) is free of the shielding layer (4).

2. Luminescence diode component according to Claim 1, **characterized in that**
the housing cavity (11) has at least one partial region which is laterally covered by a housing material that laterally delimits the housing cavity (11).

3. Luminescence diode component according to either of the preceding claims,
**characterized in that**
an electrical contact area (32) for electrically conductively contacting the luminescence diode chip (3) is contained within the housing cavity (11), wherein at least one part of the electrical contact area (32) is laterally covered by a housing material that laterally delimits the housing cavity (11).

4. Luminescence diode component according to any of the preceding claims,
**characterized in that**
a part of the chip mounting region (33) is offset laterally with respect to the output opening (12).

5. Luminescence diode component according to any of the preceding claims,
**characterized in that**
a plurality of chip mounting regions (33) are contained which are arranged in a linear arrangement with respect to one another.

6. Luminescence diode component according to any of the preceding claims,
**characterized in that**
a frame (17) that laterally delimits the housing cavity (11) is contained, which frame is at least partly light-transmissive.

7. Luminescence diode component according to any of the preceding claims,
**characterized in that**
the housing cavity (11) has a depth of less than or equal to 500 µm.

8. Luminescence diode component according to any of the preceding claims,
**characterized in that**
a housing frame (17) that laterally surrounds the housing cavity (11) has a thickness of less than or equal to 1.5 mm in the lateral direction.

9. Luminescence diode component according to Claim 8,
**characterized in that**
a luminescence conversion material is arranged in the housing cavity (11), said luminescence conversion material comprising at least one phosphor (61) that can be excited by an electromagnetic radiation emitted by the luminescence diode chip (3).

## Revendications

1. Composant à diodes électroluminescentes (2), comprenant un boîtier (1) pourvu d'une cavité de boîtier (11), à l'intérieur duquel est disposée au moins une région de montage de puces (33) pour une puce à diodes électroluminescentes (3) et qui comporte une ouverture de sortie (12), et pourvu d'une puce à diodes électroluminescentes (3) qui est montée sur la région de montage de puces (33), dans lequel
- le boîtier (2) comporte, à au moins une certaine distance verticale de la région de montage de puces (33), des parois internes qui délimitent latéralement la cavité de boîtier (11) et qui présentent, dans une direction latérale qui s'étend parallèlement à un plan de montage de puces (34) de la région de montage de puces (33), une distance maximale inférieure ou égale à 500 µm par rapport à la région de montage de puces (33), et
- une première partie d'une surface extérieure (5) du boîtier (1), qui est adjacent à l'ouverture de sortie (12) de la cavité de boîtier (11) et est munie d'une couche de blindage (4) qui est appropriée pour le blindage vis-à-vis d'un domaine spectral du rayonnement électromagnétique émis par la puce à diodes électroluminescentes (3),
- **caractérisé en ce qu'**une seconde partie de la surface extérieure (5) adjacente à l'ouverture de sortie (12) est dépourvue de la couche de blindage (4).

2. Composant à diodes électroluminescentes selon la revendication 1,
**caractérisé en ce que** la cavité de boîtier (11) comporte au moins une région partielle qui est revêtue latéralement d'un matériau de boîtier délimitant latéralement la cavité de boîtier (11).

3. Composant à diodes électroluminescentes selon l'une quelconque des revendications précédentes,
**caractérisé en ce qu'**une surface de contact électrique (32) destinée à établir un contact électriquement conducteur avec la puce à diodes électroluminescentes (3) est contenue à l'intérieur de la cavité de boîtier (11), dans lequel au moins une partie de la surface de contact électrique (32) est revêtue latéralement d'un matériau de boîtier délimitant latéralement la cavité de boîtier (11).

4. Composant à diodes électroluminescentes selon l'une quelconque des revendications précédentes,
**caractérisé en ce qu'**une partie de la région de montage de puce (33) est décalée latéralement par rapport à l'ouverture de sortie (12).

5. Composant à diodes électroluminescentes selon l'une quelconque des revendications précédentes,
**caractérisé en ce qu'**il est prévu une pluralité de régions de montage de puces (33) qui sont disposées selon un agencement linéaire les unes par rapport aux autres.

6. Composant à diodes électroluminescentes selon l'une quelconque des revendications précédentes,
**caractérisé en ce qu'**il est prévu un châssis (17) délimitant latéralement la cavité de boîtier (11) qui est au moins partiellement transparent à la lumière.

7. Composant à diodes électroluminescentes selon l'une quelconque des revendications précédentes,
**caractérisé en ce que** la cavité de boîtier (11) présente une profondeur inférieure ou égale à 500 µm.

8. Composant à diodes électroluminescentes selon l'une quelconque des revendications précédentes,
**caractérisé en ce qu'**un châssis de boîtier (17) entourant latéralement la cavité de boîtier (11) présente dans la direction latérale une épaisseur inférieure ou égale à 1,5 mm.

9. Composant à diodes électroluminescentes selon la revendication 8,
**caractérisé en ce qu'**un matériau de conversion de luminescence est disposé dans la cavité de boîtier (11), lequel matériau de conversion de luminescence comporte un matériau luminescent (61) pouvant être excité par un rayonnement électromagnétique émis par la puce à diode électroluminescentes (3).
